# EUROPÄISCHE PATENTSCHRIFT

(11) **EP 0 820 639 B1**
(45) Veröffentlichungstag und Bekanntmachung des Hinweises auf die Patenterteilung: **24.10.2001**
(21) Anmeldenummer: 96907305.5
(22) Anmeldetag: 29.03.1996
(51) Int. Cl.: H01L 21/30, H01L 23/31

(54) **VERFAHREN ZUM PASSIVIEREN EINER SILICIUMCARBID-OBERFLÄCHE GEGENÜBER SAUERSTOFF**
PROCESS FOR PASSIVATING A SILICON CARBIDE SURFACE AGAINST OXYGEN
PROCEDE DE PASSIVATION D'UNE SURFACE DE CARBURE DE SILICIUM VIS-A-VIS DE L'OXYGENE

(30) Priorität: 13.04.1995 DE 19514079
(43) Veröffentlichungstag der Anmeldung: 28.01.1998
(73) Patentinhaber: SiCED Electronics Development GmbH & Co KG, 91052 Erlangen (DE)
(72) Erfinder: RUPP, Roland, D-91207 Lauf (DE)
(74) Vertreter: Zedlitz, Peter, Dipl.-Inf.
(86) Internationale Anmeldenummer: DE9600553
(87) Internationale Veröffentlichungsnummer: WO9632740

(56) Entgegenhaltungen:
- EP-A- 0 381 111
- SYMPOSIUM C: ION BEAM, PLASMA, LASER, AND THERMALLY-STIMULATED DEPOSITION PROCESSES AT THE SPRING MEETING OF THE EUROPEAN MATERIALS RESEARCH SOCIETY CONFERENCE, STRASBOURG, FRANCE, 4-7 MAY 1993, Bd. 241, Nr. 1-2, ISSN 0040-6090, THIN SOLID FILMS, 1 APRIL 1994, SWITZERLAND, Seiten 305-309, XP000440482 DIANI M ET AL: "Electron cyclotron resonance plasma ion beam effects on the formation of SiC on Si(001) characterized by in-situ photoemission"
- APPLIED PHYSICS LETTERS, Bd. 66, Nr. 12, 20.März 1995, Seite 1501/1502 XP000500905 HARRIS C I ET AL: "SIC POWER DEVICE PASSIVATION USING POROUS SIC"
- JOURNAL OF APPLIED PHYSICS, 15 OCT. 1986, USA, Bd. 60, Nr. 8, ISSN 0021-8979, Seiten 2842-2853, XP000570880 MUEHLHOFF L ET AL: "Comparative electron spectroscopic studies of surface segregation on SiC(0001) and SiC(0001)" in der Anmeldung erwähnt
- PROCEEDINGS OF THE 32ND NATIONAL SYMPOSIUM OF THE AMERICAN VACUUM SOCIETY, HOUSTON, TX, USA, 19-22 NOV. 1985, Bd. 4, Nr. 3, pt.2, ISSN 0734-2101, JOURNAL OF VACUUM SCIENCE & TECHNOLOGY A (VACUUM, SURFACES, AND FILMS), MAY-JUNE 1986, USA, Seiten 1692-1695, XP002011767 BELLINA J J JR ET AL: "Surface modification strategies for (100)3C-SiC"
- PROCEEDINGS OF THE SEVENTH SYMPOSIUM ON APPLIED SURFACE ANALYSIS, COLLEGE PARK, MD, USA, 15-17 MAY 1985, Bd. 25, Nr. 4, ISSN 0169-4332, APPLIED SURFACE SCIENCE, MAY 1986, NETHERLANDS, Seiten 380-390, XP000600366 BELLINA J J JR ET AL: "Stoichiometric changes in the surface of (100) cubic SiC caused by ion bombardment and annealing"
- JOURNAL OF CRYSTAL GROWTH, Bd. 146, Nr. 1/04, 1.Januar 1995, Seiten 37-41, XP000511839 RUPP R ET AL: "FIRST RESULTS ON SILICON CARBIDE VAPOUR PHASE EPITAXY GROWTH IN A NEW TYPE OF VERTICAL LOW PRESSURE CHEMICAL VAPOUR DEPOSITION REACTOR"

## Beschreibung

Die Erfindung betrifft ein Verfahren zum Passivieren einer Siliciumcarbid (SiC)-Oberfläche gegenüber Sauerstoff.

Es sind eine Vielzahl von Halbleiterstrukturen auf der Basis von Siliciumcarbid (SiC) als Halbleitermaterial bekannt. Beim Herstellen solcher SiC-Halbleiterstrukturen müssen die Oberflächen von gegebenenfalls bereits vorbearbeiteten SiC-Einkristallen häufig einer sauerstoffhaltigen Atmosphäre ausgesetzt werden, beispielsweise beim Zwischenlagern des SiC-Einkristalls oder Transport von einem Prozeßort zu einem anderen. In einer sauerstoffhaltigen Atmosphäre bildet sich jedoch an der Oberfläche des SiC-Einkristalls eine natürliche Oxidschicht aus SiO₂. An Luft beträgt die Dicke dieser Oxidschicht beispielsweise nach einer Woche bereits 2 nm. Diese natürliche Oxidschicht ist im allgemeinen unerwünscht und muß daher vor einem anschließenden Prozeßschritt durch Sputtern oder mit Fluorsäure (HF) entfernt werden.

Aus der Veröffentlichung "Thin Solid Films 241 (1994), p-305-309, ist es bekannt, Siliciumcarbid-Oberflächen mit einem Wasserstoff(H₂)-Plasma zu behandeln und durch Anlagerung von H₂-Ionen die freien Bindungen an der SiC-Oberfläche abzusättigen. Damit ist eine allgemeine Passivierung erreicht.

Aufgabe der Erfindung ist nun, eine SiC-Oberfläche gegenüber Sauerstoff zu passivieren, um eine Oxidbelegung dieser SiC-Oberfläche in einer sauerstoffhaltigen Atmosphäre zu vermeiden.

Diese Aufgabe wird gemäß der Erfindung gelöst mit den Merkmalen des Anspruchs 1.

Der Erfindung liegt die Überlegung zugrunde, zum Passivieren der SiC-Oberfläche eine Kohlenstoffschicht zu verwenden. Auf der Kohlenstoffschicht bildet sich wegen der geringen chemischen Affinität von Kohlenstoff zu Sauerstoff im Gegensatz zu einer freien SiC-Oberfläche keine Oxidschicht. Die mit dieser Kohlenstoffpassivierung versehene SiC-Oberfläche kann deshalb praktisch beliebig lange in einer sauerstoffhaltigen Atmosphäre wie beispielsweise Luft gelagert oder transportiert werden.

Das Verfahren ist besonders vorteilhaft beim Herstellen einer Halbleiterstruktur, bei dem die Oberfläche eines SiC-Einkristalls zwischen einem ersten und einem zweiten Prozeßschritt einer sauerstoffhaltigen Atmosphäre ausgesetzt werden muß. Bevor der SiC-Einkristall mit dem sauerstoffhaltigen Gasgemisch in Berührung kommt, wird an wenigstens einem Teil seiner SiC-Oberfläche eine Kohlenstoffschicht erzeugt, die gegenüber Sauerstoff im wesentlichen chemisch inert ist. Die Kohlenstoffschicht kann dann unmittelbar vor dem zweiten Prozeßschritt wieder entfernt werden oder in diesem zweiten Prozeßschritt weiterverarbeitet werden.

Vorteilhafte Ausgestaltungen und Weiterbildungen des Passivierungsverfahrens gemäß der Erfindung ergeben sich aus den vom Anspruch 1 abhängigen Ansprüchen.

Die Kohlenstoffschicht wird in einer besonders vorteilhaften Ausführungsform durch Abdampfen (Absublimieren) von Siliciumatomen von der SiC-Oberfläche erzeugt. Vorzugsweise wird die SiC-Oberfläche dazu in einem Vakuum oder in einer Inertgasatmosphäre auf eine Temperatur von wenigstens etwa 1000° C gebracht. Die Kohlenstoffschicht kann aber auch durch chemische Dampfabscheidung (CVD) oder Molekularstrahlepitaxie (MBE) erzeugt werden. Vorzugsweise wird eine Kohlenstoffschicht mit einer der Struktur von Graphit zumindest ähnlichen Kristallstruktur erzeugt. Die Dicke der Kohlenstoffschicht wird in einer bevorzugten Ausführungsform kleiner als 1 nm eingestellt. Die Kohlenstoffschicht umfaßt dann nur wenige Atomlagen oder sogar nur eine Atomlage von Kohlenstoffatomen.

In einer weiteren Ausführungsform wird die SiC-Oberfläche vor dem Erzeugen der Kohlenstoffschicht bei Temperaturen von wenigstens 500°C in einer Wasserstoffatmosphäre von gebundenem Sauerstoff gereinigt.

Die Erfindung wird nun anhand von Ausführungsbeispielen weiter erläutert.

In einem ersten Ausführungsbeispiel des Verfahrens zum Schutz einer SiC-Oberfläche vor Oxidation wird der SiC-Oberfläche Kohlenstoff in elementarer Form C, beispielsweise durch Sputtern, oder in Form einer chemischen Kohlenstoffverbindung, beispielsweise durch CVD oder MBE, zugeführt. Aus dem zugeführten Kohlenstoff wird auf der SiC-Oberfläche eine Kohlenstoffschicht abgeschieden. Bei einem CVD-Prozeß oder einem MBE-Prozeß wird im allgemeinen ein Kohlenwasserstoffgas wie beispielsweise C₂H₂ verwendet, aus dem sich bei geeignet eingestellten Prozeßbedingungen wie insbesondere Druck und Temperatur durch chemische Reaktionen im Bereich der SiC-Oberfläche die Kohlenstoffschicht bildet. Typische Prozeßtemperaturen für das Wachstum der Kohlenstoffschicht liegen zwischen 500°C und 1500°C.

In einem zweiten Ausführungsbeispiel des Antioxidations- oder Passivierungsverfahrens werden im SiC gebundene Siliciumatome von der SiC-Oberfläche und/oder dem darunterliegenden SiC entfernt, vorzugsweise abgedampft. Zum Abdampfen (Absublimieren) der Siliciumatome wird die SiC-Oberfläche vorzugsweise einer Wärmebehandlung bei Temperaturen von wenigstens 1000°C unterzogen, vorzugsweise in einem Vakuum oder in einer Inertgasatmosphäre bei im Prinzip beliebigen Drücken, insbesondere zwischen 20 Torr und 1000 Torr. Unter einem Inertgas wird dabei ein Gas verstanden, das bei den verwendeten Temperaturen chemisch mit SiC praktisch nicht reagiert, beispielsweise Argon (Ar). Da der Dampfdruck von Silicium (Si) im SiC höher ist als der Dampfdruck des Kohlenstoff (C), bleibt beim Abdampfen der Siliciumatome an der SiC-Oberfläche ein Überschuß an Kohlenstoffatomen zurück. Diese überschüssigen Kohlenstoffatome formieren sich zu einer Kohlenstoffschicht. Es ergibt sich eine neue, etwas zurückgewichene SiC-Oberfläche, die an die Kohlenstoffschicht angrenzt.

Sowohl durch Zuführen von Kohlenstoff gemäß dem ersten Ausführungsbeispiel als auch durch Verdampfen von Silicium gemäß dem zweiten Ausführungsbeispiel wird also an der SiC-Oberfläche eine Kohlenstoffschicht erzeugt. Mit dieser Kohlenstoffterminierung kann die SiC-Oberfläche nun einem sauerstoffhaltigen Gas wie beispielsweise Luft ausgesetzt werden. An der Kohlenstoffschicht bildet sich nämlich auch bei hohen Temperaturen keine feste Oxidschicht. Bei Temperaturen um Raumtemperatur (25°C) ist der Kohlenstoff der Kohlenstoffschicht praktisch überhaupt nicht reaktiv mit Sauerstoff. Bei höheren Temperaturen bilden sich im wesentlichen nur flüchtige Kohlenstoffoxide. Die Kohlenstoffschicht kann beispielsweise mit einer im wesentlichen amorphen Struktur und vorzugsweise mit einer Graphitstruktur oder zumindest graphitähnlichen Struktur hergestellt werden. In einer vorteilhaften Ausführungsform wird eine unter 1 nm dicke Kohlenstoffschicht erzeugt.

In einem dritten Ausführungsbeispiel des Verfahrens wird eine Oxidbelegung an einer Oberfläche eines SiC-Einkristalls als SiC-Oberfläche vermieden. Als SiC-Oberfläche wird dann vorzugsweise eine der polaren Seiten (basal planes), also eine Siliciumseite oder eine Kohlenstoffseite, des SiC-Einkristalls verwendet. Die Siliciumseite entspricht einer (1 1 1)-Kristallfläche im polaren Kristallgitter bei einem SiC-Einkristall vom kubischen Polytyp 3C (β-SiC) und einer (0 0 0 1)-Kristallfläche im polaren Kristallgitter eines SiC-Einkristalls von einem nicht kubischen Polytyp wie beispielsweise 4H, 6H oder 15R (α-SiC). Unter der Kohlenstoffseite versteht man dagegen eine (-1 -1 -1)-Kristallfläche im polaren Kristallgitter bei einem SiC-Einkristall vom kubischen Polytyp 3C (β-SiC) und eine (0 0 0 -1)-Kristallfläche im polaren Kristallgitter eines SiC-Einkristalls von einem nicht kubischen Polytyp wie beispielsweise 4H, 6H oder 15R (α-SiC).

In diesem dritten Ausführungsbeispiel des Verfahrens wird nun die Kohlenstoffschicht vorzugsweise wie beim zweiten Ausführungsbeispiel durch Abdampfen von Siliciumatomen von der SiC-Oberfläche erzeugt. Die Siliciumseite oder die Kohlenstoffseite des SiC-Einkristalls wird dazu einer bereits beschriebenen Wärmebehandlung bei Temperaturen von wenigstens 1000°C im Vakuum oder in einem Inertgas unterzogen. Durch den zeitlichen Verlauf der Wärmebehandlung und die verwendeten Temperaturen kann sehr genau eingestellt werden, wie viele einzelne (1 1 1)- bzw. (0 0 0 1)-Siliciumatomlagen aus dem SiC-Kristallgitter entfernt werden. Insbesondere kann auch nur die oberste Siliciumatomlage entfernt werden. Man erhält dann an der Siliciumseite eine sehr dünne Kohlenstoffschicht aus nur einer Monolage von Kohlenstoffatomen und an der Kohlenstoffseite eine Kohlenstoffschicht aus zwei Kohlenstoffatomlagen. Der an der Oberfläche zurückgebliebene Kohlenstoff rekonstruiert im allgemeinen durch Sättigen der offenen Bindungen zu einer Graphitstruktur oder einer graphitähnlichen Struktur (Graphitisierung). Das Abdampfen von Siliciumatomen von der Siliciumseite oder der Kohlenstoffseite eines SiC-Einkristalls bei verschiedenen Wärmebehandlungen und spektroskopische Untersuchungen der entstehenden Kohlenstoffschichten sind in dem Artikel *Muehlhoff et al* "*Comparative electron spectroscopic studies of surface segregation on SiC (0 0 0 1) und SiC (0 0 0 -1)*", *Journal of Applied Physics, Vol. 60, No. 8, 15 October 1986, Seiten 2842 bis 2853* beschrieben, dessen Inhalt als in die Offenbarung dieser Anmeldung miteinbezogen wird.

Die SiC-Oberfläche Rann vor dem Erzeugen der Kohlenstoffschicht von gebundenem Sauerstoff gereinigt werden. Dazu eignen sich insbesondere Plasmaätzen, Ätzen mit Fluorsäure (HF) und vorzugsweise eine Wärmebehandlung in einer im wesentlichen reinen Wasserstoffatmosphäre bei Temperaturen von wenigstens 500°C, insbesondere wenigstens 800°C und vorzugsweise wenigstens 1200°C. Der Druck wird dabei vorzugsweise größer als etwa 5 mbar eingestellt.

Ferner Kann das Verfahren zum Passivieren einer SiC-Oberfläche gegenüber Sauerstoff in einem Halbleiter-Herstellungsprozeß eingesetzt werden, in dem die SiC-Oberfläche eines SiC-Einkristalls zwischen zwei Prozeßschritten einer sauerstoffhaltigen Atmosphäre ausgesetzt wird. Ein Beispiel für eine solche Sauerstoffexposition ist das Transportieren oder Lagern eines einkristallinen SiC-Halbleitersubstrats oder einer auf einem Substrat angeordneten SiC-Epitaxieschicht in Luft vor weiteren Bearbeitungsschritten wie Strukturierung, Dotierung oder Kontaktierung.

Die zum Schutz vor Oxidation erzeugte Kohlenstoffschicht kann vor einem weiteren Prozeßschritt wieder entfernt werden, und die frei gelegte SiC-Oberfläche kann in diesem Prozeßschritt weiterbearbeitet werden. Zum Entfernen der Kohlenstoffschicht kann ein Plasmaätzverfahren in Wasserstoff (H₂) verwendet werden.

Alternativ dazu kann die Kohlenstoffschicht in dem weiteren Prozeßschritt wenigstens teilweise mit wenigstens einem carbidbildenden Metall wie beispielsweise Wolfram (W), Titan (Ti), Tantal (Ta), Bor (B), Aluminium (Al), Nickel (Ni) oder Scandium (Sc) in eine Metallcarbidschicht umgewandelt werden, um einen elektrischen Kontakt auf der Oberfläche des SiC-Einkristalls herzustellen. Die Metallcarbidschicht auf dem SiC-Einkristall wird vorzugsweise als Schottky-Kontakt verwendet.

Der SiC-Einkristall wird in allen Ausführungsbeispielen vorzugsweise durch chemische Dampfabscheidung (Chemical Vapour Deposition = CVD) oder Molekularstrahlepitaxie (Molecular Beam Epitaxy = MBE) als SiC-Schicht auf einem Substrat bei Temperaturen von im allgemeinen wenigstens 1100°C und vorzugsweise wenigstens 1500°C aufgewachsen. Eine besondere Variante zur Herstellung des SiC-Einkristalls ist die Atomlagenepitaxie (Atomic Layer Epitaxy = ALE), bei der in aufeinanderfolgenden CVD- oder MBE-Prozeßschritten abwechselnd Siliciumatomlagen und Kohlenstoffatomlagen erzeugt werden zum Aufbau des SiC-Kristallgitters. Die Kohlenstoffschicht kann dann unmittelbar anschließend ebenfalls durch CVD bzw. MBE hergestellt werden, indem die Siliciumzufuhr zum aufwachsenden SiC-Einkristall gestoppt wird und nur noch Kohlenstoff zugeführt wird. Ferner kann die Kohlenstoffschicht auch unmittelbar anschließend an den CVD-Prozeß bzw. den MBE-Prozeß zum Herstellen des SiC-Einkristalls erzeugt werden, indem sowohl die Silicium- als auch die Kohlenstoffzufuhr unterbrochen wird und der SiC-Einkristall im Vakuum oder in einer Inertgasatmosphäre mit einem vorgegebenen zeitlichen Temperaturverlauf im allgemeinen bis auf Raumtemperatur abgekühlt wird.

Der SiC-Einkristall kann aber auch durch einen Sublimationsprozeß hergestellt sein.

## Patentansprüche

1. Verfahren zum Passivieren einer Siliciumcarbid (SiC)-Oberfläche gegenüber Sauerstoff, bei dem an der SiC-Oberfläche eines SiC EinKristalls eine mindestens eine Atomlage umfassende Kohlenstoffschicht erzeugt wird.

2. Verfahren nach Anspruch 1, bei dem als SiC-Oberfläche eine Siliciumseite des SiC-Einkristalls verwendet wird, die bei einem kubischen Polytyp des SiC (β-SiC) einer (1 1 1)-Kristallfläche und bei einem nicht kubischen Polytyp (α-SiC) einer (0 0 0 1)-Kristallfläche entspricht.

3. Verfahren nach Anspruch 1, bei dem als SiC-Oberfläche eine Kohlenstoffseite des SiC-Einkristalls verwendet wird, die bei einem kubischen Polytyp des SiC (β-SiC) einer (-1 -1 -1)-Kristallfläche und bei einem nicht kubischen Polytyp (α-SiC) einer (0 0 0 -1)-Kristallfläche entspricht.

4. Verfahren nach einem der vorhergehenden Ansprüche, bei dem die Kohlenstoffschicht eine Graphitstruktur oder eine graphitähnliche Kristallstruktur aufweist.

5. Verfahren nach einem der vorhergehenden Ansprüche, bei dem die Kohlenstoffschicht durch Abdampfen von Siliciumatomen von der SiC-Oberfläche erzeugt wird.

6. Verfahren nach Anspruch 5, bei dem die Siliciumatome abgedampft werden, indem die SiC-Oberfläche einem Vakuum oder einer Edelgasatmosphäre bei Temperaturen von wenigstens 1000° C ausgesetzt wird.

7. Verfahren nach einem der Ansprüche 1 bis 4, bei dem die Kohlenstoffschicht durch chemische Dampfabscheidung (CVD) erzeugt wird.

8. Verfahren nach einem der Ansprüche 1 bis 4, bei dem die Kohlenstoffschicht durch Molekularstrahlepitaxie (MBE) erzeugt wird.

9. Verfahren nach einem der vorhergehenden Ansprüche, bei dem eine Kohlenstoffschicht mit einer Dicke unter 1 nm erzeugt wird.

10. Verfahren nach einem der vorhergehenden Ansprüche, bei dem die SiC-Oberfläche vor dem Erzeugen der Kohlenstoffschicht einer Wasserstoffatmosphäre bei Temperaturen von wenigstens 500° C ausgesetzt wird.

## Claims

1. Method for passivating a silicon carbide (SiC) surface against oxygen, wherein a carbon coating comprising at least one atomic layer is produced on the SiC surface of a SiC single crystal.

2. Method according to claim 1, wherein a silicon plane of the SiC single crystal, which in the case of a cubic polytype of the SiC (β-Sic) corresponds to a (1 1 1)-crystal face and in the case of a non cubic polytype (α-Sic) corresponds to a (0 0 0 1)-crystal face, is used as the SiC surface.

3. Method according to claim 1, wherein a carbon plane of the SiC single crystal, which in the case of a cubic polytype of the SiC (β-Sic) corresponds to a (-1 -1 -1)-crystal face and in the case of a non cubic polytype (α-Sic) corresponds to a (0 0 0 -1)-crystal face, is used as the SiC surface.

4. Method according to one of the preceding claims, wherein the carbon coating has a graphite structure or a graphite-like crystal structure.

5. Method according to one of the preceding claims, wherein the carbon coating is produced by evaporating silicon atoms off from the SiC surface.

6. Method according to claim 5, wherein the silicon atoms are evaporated by exposing the SiC surface to a vacuum or an inert gas atmosphere at temperatures of at least 1000°C.

7. Method according to one of claims 1 to 4, wherein the carbon coating is produced by chemical vapour deposition (CVD).

8. Method according to one of claims 1 to 4, wherein the carbon coating is produced by molecular beam epitaxy (MBE).

9. Method according to one of the preceding claims, wherein a carbon coating is produced with a thickness of less than 1 nm.

10. Method according to one of the preceding claims, wherein the SiC surface is exposed to a hydrogen atmosphere at temperatures of at least 500°C before the carbon coating is produced.

## Revendications

1. Procédé de passivation d'une surface en carbure de silicium (SiC) vis à vis de l'oxygène, dans lequel on produit sur la surface de SiC d'un monocristal de SiC une couche de carbone comprenant au moins une strate atomique.

2. Procédé suivant la revendication 1, dans lequel on utilise comme surface de SiC une face de silicium d'un monocristal de SiC qui, dans un polytype cubique du SiC (SiCβ), correspond à une surface cristalline (1 1 1) et dans un polytype non cubique (SiCα) à une surface cristalline (0 0 0 1).

3. Procédé suivant la revendication 1, dans lequel on utilise comme surface de SiC une face de carbone du cristal de SiC qui, pour un polytype cubique du SiC (SiCβ), correspond à une surface cristalline (-1 -1 -1) et pour un polytype non cubique (SiCα) à une surface cristalline (0 0 0 -1).

4. Procédé suivant l'une des revendications précédentes, dans lequel la couche de carbone a une structure de graphite ou une structure cristalline analogue au graphite.

5. Procédé suivant l'une des revendications précédentes, dans lequel la couche de carbone est produite par évaporation d'atomes de silicium de la surface de SiC.

6. Procédé suivant la revendication 5 dans lequel les atomes de silicium sont évaporés en mettant la surface de SiC sous vide ou sous une atmosphère de gaz rare à des températures d'au moins 1000°C.

7. Procédé suivant l'une des revendications 1 à 4, dans lequel la couche de carbone est produite par dépôt chimique en phase vapeur (CVD).

8. Procédé suivant l'une des revendications 1 à 4, dans lequel la couche de carbone est produite par épitaxie par faisceau moléculaire (MBE).

9. Procédé suivant l'une des revendications précédentes, dans lequel il est produit une couche de carbone d'une épaisseur inférieure 1 nm.

10. Procédé suivant l'une des revendications précédentes, dans lequel la surface de SiC est soumise avant la production de la couche de carbone à une atmosphère d'hydrogène à des températures de 500°C.
